# FASCICULE DE BREVET EUROPEEN

(11) **EP 1 692 761 B1**
(45) Date de publication et mention de la délivrance du brevet: **24.04.2013**
(21) Numéro de dépôt: 04797910.9
(22) Date de dépôt: 16.11.2004
(51) Int. Cl.: H03H 9/10, H03H 9/215, H03H 9/05

(54) **COMPOSANT ELECTRONIQUE AYANT UN ELEMENT RESONATEUR DANS UN BOITIER HERMETIQUEMENT FERME**
EIN ELEKTRONISCHES BAUELEMENT MIT EINEM RESONATORELEMENT IN EINEM HERMETISCH ABGESCHLOSSENEN GEHÄUSE
ELECTRONIC COMPONENT HAVING A RESONATOR ELEMENT IN A HERMETICALLY CLOSED CASE

(30) Priorité: 25.11.2003 EP 03027066
(43) Date de publication de la demande: 23.08.2006
(73) Titulaire: ETA SA Manufacture Horlogère Suisse, 2540 Grenchen (CH)
(72) Inventeur: DALLA PIAZZA, Silvio, CH-2610 St-Imier (CH); LUETHI, Thomas, CH-2540 Grenchen (CH)
(74) Mandataire: Ravenel, Thierry Gérard Louis
(86) Numéro de dépôt international: PCT/EP2004/012949
(87) Numéro de publication internationale: WO 2005/055422

(56) Documents cités:
- US-A- 3 766 616
- US-A- 4 191 905
- US-A1- 2002 113 523
- PATENT ABSTRACTS OF JAPAN vol. 1999, no. 10, 31 août 1999 (1999-08-31) & JP 11 145769 A (SUMITOMO METAL SMI ELECTRON DEVICES INC), 28 mai 1999 (1999-05-28)

## Description

La présente invention concerne un composant électronique ayant un élément résonateur dans un boîtier hermétiquement fermé. Ledit boîtier comprend une partie principale avec une base et au moins une paroi latérale de forme annulaire, et un couvercle fixé sur la partie principale. Au moins une portion du couvercle est transparente à une longueur d'onde déterminée d'un faisceau de lumière pour permettre un réglage optique de l'élément résonateur.

L'invention concerne également un procédé de fabrication d'un composant électronique. Le procédé comprend des étapes consistant à réaliser la partie principale du boîtier par un empilement et une fixation de feuilles en matériau dur, tel qu'en céramique, et à monter un élément résonateur dans un logement du boîtier avant de fermer le boîtier à l'aide du couvercle. Ces feuilles sont ouvragées pour définir une base et au moins une paroi latérale.

L'élément résonateur peut être par exemple un résonateur piézo-électrique, tel qu'un résonateur à quartz destiné à être relié à un circuit oscillateur. La plupart des résonateurs à quartz de petites dimensions, qui sont utilisés par exemple dans les montres électroniques ou électromécaniques, sont des résonateurs à diapason en quartz. Ces résonateurs à quartz sont habituellement enfermés sous vide dans des boîtiers, dans le cas de la génération de signaux basse fréquence fournis par le circuit oscillateur, ou sous atmosphère de gaz inerte.

Généralement, de tels résonateurs sont montés dans des boîtiers par exemple en céramique qui sont relativement plats. Ces boîtiers comprennent généralement une partie principale de forme parallélépipédique à l'intérieur de laquelle est monté le résonateur, et un couvercle rectangulaire fixé sur la partie principale. Si le résonateur est enfermé sous vide dans le boîtier, le réglage dudit résonateur peut être réalisé optiquement à travers le couvercle transparent.

On peut citer à ce titre le document JP 54-35870 U qui décrit un composant électronique avec un élément résonateur qui est disposé dans un premier logement d'une partie principale d'un boîtier. Ce premier logement est fermé hermétiquement par un couvercle transparent fixé à l'aide d'une préforme sur un bord annulaire du premier logement de la partie principale. Un circuit intégré oscillateur est disposé dans un second logement de la partie principale du boîtier qui est séparé du premier logement par une base. Le second logement est fermé par un couvercle opaque fixé sur un bord annulaire du second logement de la partie principale. Le circuit intégré est relié électriquement à l'élément résonateur à travers la base de la partie principale du boîtier.

Un inconvénient d'un tel composant électronique décrit dans le document JP 54-35870 U est que, lors de chocs latéraux au niveau de chaque couvercle, des fissures du couvercle ou du matériau fixant le couvercle sur la partie principale peuvent survenir, induisant ainsi une perte d'étanchéité. Ces chocs latéraux peuvent intervenir lors de diverses manipulations, notamment lors des opérations de montage dudit composant électronique dans un appareil électronique ou sur une plaque de circuit imprimé. Comme habituellement l'élément résonateur doit rester enfermé sous vide dans son boîtier ou dans une atmosphère de gaz inerte, le réglage de l'élément résonateur pour la génération de signaux à fréquence déterminée du circuit oscillateur peut être faussé. Le résonateur peut même cesser d'osciller. Pour minimiser ces problèmes, il est nécessaire de meuler les coins et les faces latérales des couvercles par des procédés spéciaux. Bien entendu, ceci augmente sensiblement le coût de tels couvercles.

Un autre inconvénient du composant électronique du document JP 54-35870 U est purement lié au procédé de fermeture. En effet, la technique communément employée pour le fermeture du boîtier est d'empiler les différents éléments dans une cavité d'une plaque métallique, à savoir la préforme sur la partie principale du boîtier, et le couvercle sur la préforme. Ainsi, les trois éléments sont positionnés précisément. Pour ce faire, la tolérance mécanique de cette cavité doit être très grande de façon à bien positionner les trois éléments.

L'invention a donc pour but principal de pallier les inconvénients de l'art antérieur en fournissant un composant électronique ayant un élément résonateur enfermé hermétiquement dans un boîtier dont le couvercle est protégé des chocs latéraux. De plus, le temps et les coûts de fabrication d'un tel composant électronique avec un couvercle du boîtier protégé peuvent être minimisés.

A cet effet, l'invention concerne un composant électronique cité ci-devant qui se caractérise en ce que le couvercle est fixé sur un rebord de la paroi latérale de la partie principale qui est réalisée en matériau dur, tel qu'en céramique, de manière qu'une partie du rebord entoure intégralement la surface latérale du couvercle pour assurer une protection du composant électronique contre des chocs latéraux.

Un avantage du composant électronique selon l'invention est qu'avec un tel rebord dont une partie entoure partiellement la surface latérale du couvercle pour le protéger des chocs latéraux, le composant électronique peut être manipulé sans risque. De préférence, une partie du rebord entoure intégralement la surface latérale du couvercle. Ceci permet de maintenir l'élément résonateur enfermé hermétiquement dans son logement par le couvercle dans une atmosphère de gaz inerte ou préférentiellement sous vide. De même, le positionnement du couvercle par rapport à la partie principale du boîtier ne dépend plus de la tolérance mécanique de cavités utilisées dans le procédé de fermeture du boîtier. Ceci réduit ainsi les risques d'un mauvais alignement du couvercle sur le rebord.

La hauteur de la partie du rebord qui entoure la surface latérale du couvercle est préférentiellement égale ou plus grande que l'épaisseur du couvercle fixé sur un épaulement du rebord, pour qu'aucune arête du couvercle ne soit en saillie de la face supérieure du rebord. Il peut être également laissé un espace entre cette partie du rebord et la surface latérale du couvercle pour assurer une meilleure protection. De cette façon, les chocs latéraux survenant contre le rebord ne se propagent pas directement contre le couvercle. Ainsi, il peut être utilisé un couvercle transparent par exemple en verre, qui est obtenu simplement par rayage et cassage d'une plaque de verre traditionnelle. Ceci réduit les coûts de fabrication d'un tel composant électronique, car il n'est plus nécessaire de travailler spécialement les bords et les angles du couvercle réalisé en verre ou en un autre matériau qui peut être friable ou cassable.

Pour la fixation du couvercle sur le rebord, une première couche annulaire de dorure est tout d'abord déposée sur le rebord, ainsi qu'une seconde couche annulaire de dorure déposée en périphérie d'une face intérieure du couvercle. Une préforme en alliage métallique est disposée entre les deux couches annulaires de dorure pour fixer le couvercle par soudure en chauffant et pressant le couvercle contre le rebord L'alliage métallique de la préforme utilisée peut être composé d'étain et d'or.

Dans le cas où l'élément résonateur doit être enfermé sous vide, il peut être évaporé dans le logement de l'élément résonateur un matériau du type getter, tel qu'une couche de titane ou de chrome. Après avoir hermétiquement fermé le logement de l'élément résonateur, la couche de chrome ou de titane peut être activée notamment chauffée par un faisceau laser pour ainsi servir de pompe à vide.

A cet effet, l'invention concerne également un procédé de fabrication du composant cité ci-devant, qui se caractérise en ce que le procédé comprend une seconde série d'étapes consistant à poser le couvercle sur le rebord de la partie principale, dont une partie entoure intégralement la surface latérale du couvercle, ledit couvercle étant positionné sur le rebord par la partie du rebord entourant la surface latérale du couvercle, et à fixer le couvercle sur le rebord en chauffant des couches métalliques disposées sur le rebord et le couvercle.

Les buts, avantages et caractéristiques du composant électronique ayant un élément résonateur, ainsi que son procédé de fabrication, apparaîtront mieux dans la description suivante d'au moins une forme d'exécution non limitative de l'invention en liaison avec les dessins dans lesquels :
La figure 1 représente une vue de dessus du composant électronique selon l'invention, et
la figure 2 représente une vue en coupe selon A-A de la figure 1 du composant électronique selon l'invention.

Dans la description suivante, toutes les parties du composant électronique qui sont bien connues d'un homme du métier dans ce domaine technique, ne seront pas expliquées en détail.

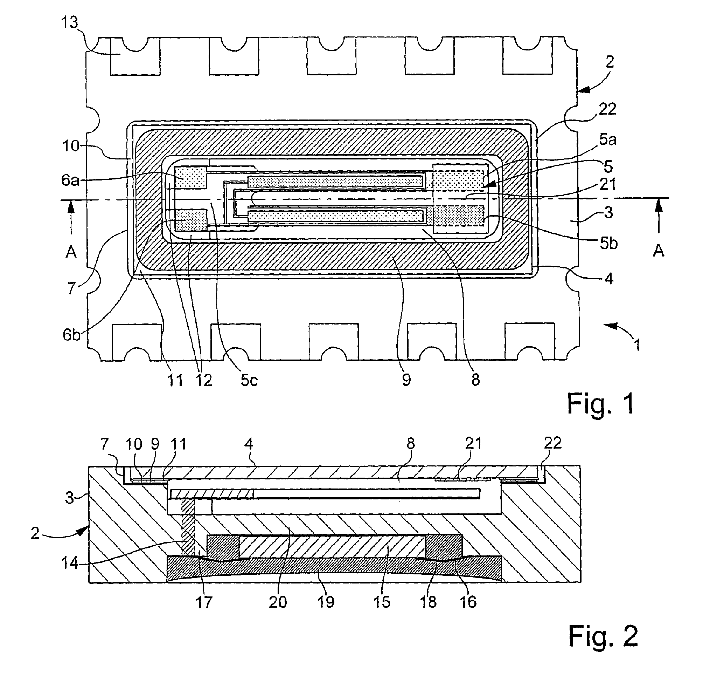

Le composant électronique 1 est représenté de manière simplifiée aux figures 1 et 2. Il comprend un élément résonateur 5 monté dans un premier logement 8 d'un boîtier de forme parallélépipédique. Le boîtier comprend une partie principale 2 avec une paroi latérale de forme annulaire 3 et une base 20, et un couvercle 4 fixé sur un épaulement d'un rebord 7 de la paroi latérale 3 pour fermer hermétiquement sous vide le logement 8 de la partie principale. Ce boîtier peut être par exemple de 5 mm de long, 3,2 mm de large et 1,08 mm de haut.

Il est à noter que le rebord 7 définit une partie supérieure de la paroi latérale 3 avec un épaulement sur lequel est fixé le couvercle 4.

La paroi latérale 3, ainsi que la base 20 de la partie principale 2 du boîtier sont de préférence réalisées en céramique selon une technique traditionnelle. Pour ce faire, plusieurs feuilles de céramique sont normalement ouvragées, empilées et fixées les unes sur les autres pour réaliser la base 20 et la paroi latérale 3 en dessus et en dessous de la base.

Une partie du rebord 7 entoure intégralement le couvercle de forme rectangulaire de manière à le protéger de tous les chocs latéraux survenant sur le composant électronique. La hauteur de la partie du rebord 7, qui entoure le couvercle 4, est supérieure ou égale à l'épaisseur du couvercle une fois fixé sur ledit rebord. De cette façon, aucune arête du couvercle n'est en saillie en dehors du boîtier.

Grâce à ce rebord 7 de la partie principale 2, le composant électronique peut être manipulé sans aucun risque. Un espace 22 sépare la surface latérale du couvercle 4 de la partie du rebord 7 qui l'entoure. L'espace peut être de dimension inférieure à l'épaisseur du couvercle. Cet espace 22 permet d'éviter de propager directement au couvercle des chocs latéraux pouvant survenir contre ledit rebord, qui sont susceptibles d'endommager le couvercle.

Le couvercle 4 de forme rectangulaire peut être avantageusement un couvercle en verre, qui est obtenu simplement par rayage et cassage d'une plaque de verre traditionnelle. Comme le couvercle est protégé par une partie du rebord 7, il n'est plus nécessaire de travailler spécialement les bords et les angles du couvercle, ce qui réduit les coûts de fabrication d'un tel composant électronique.

Pour la fixation du couvercle 4 sur le rebord 7, une première couche annulaire de dorure 10 est déposée par évaporation, ou par une autre méthode, sur le côté intérieur du rebord 7, notamment sur l'épaulement, et une seconde couche annulaire de dorure 11 est déposée par évaporation, ou par une autre méthode, à la périphérie d'une face intérieure du couvercle 4. Cette seconde couche annulaire 11 n'est pas représentée à la figure 1 de manière à ne pas surcharger le dessin. Une préforme annulaire 9 en alliage métallique est disposée entre les deux couches annulaires de dorure 10 et 11 afin de pouvoir souder le couvercle 4 sur l'épaulement du rebord 7 en chauffant sous vide et pressant le couvercle 4 contre le rebord 7. Cette préforme est par exemple en alliage eutectique d'or et d'étain afin d'avoir une température de fusion supérieure à la température utilisée dans les procédés de montage subséquent du composant électronique 1.

L'élément résonateur 5, enfermé sous vide dans le logement 8 de la partie principale 2, est de préférence un résonateur piézo-électrique, qui comprend un diapason en quartz. Ce diapason en quartz classique est constitué de deux branches parallèles 5a et 5b pour vibrer en mode de flexion, qui sont maintenues à leur base par un pont 5c. Des couches de métallisation sont déposées sur chaque branche 5a et 5b et sur le pont 5c pour constituer deux groupes d'électrodes 6a et 6b afin de les soumettre à des champs électriques susceptibles de faire vibrer lesdites branches 5a et 5b. Le pont 5c est fixé dans un coin du logement 8 sur deux plots 12 venant de matière avec la base 20 et la paroi latérale 3 pour laisser un espace aux branches 5a et 5b pour vibrer dans le logement 8 entre la base 20 et le couvercle 4.

Pour plus de détails sur la réalisation ou le fonctionnement d'un tel résonateur, le lecteur se reportera à l'enseignement tiré des demandes de brevet européen EP 1 111 770 A1 et EP 1 303 042 A1.

L'ajustage ou le réglage du résonateur à quartz est réalisé classiquement sur le produit fini, c'est-à-dire quand le couvercle ferme hermétiquement sous vide le logement 8 du boîtier. Pour ce réglage, le couvercle 4 comprend au moins une portion transparente à une longueur d'onde déterminée d'un faisceau de lumière, tel qu'un faisceau laser. Ce couvercle peut être de préférence réalisé en verre comme décrit ci-devant, ou également en silicium qui est transparent aux longueurs d'ondes supérieures à 1,3 µm. Le faisceau laser utilisé dans ce cas doit donc être d'une longueur d'onde égale ou supérieure à 1,3 µm.

Dans cette forme d'exécution présentée aux figures 1 et 2, le composant électronique 1 comprend encore un second logement 18 dans la partie principale 2, qui est délimité par la paroi latérale 3 et la base 20. Ce second logement 18 est disposé sur une face opposée de la base par rapport au logement 8 de l'élément résonateur 5. Un circuit intégré 15 ayant un étage oscillateur est fixé sur la base 20 dans ce second logement 18.

Plusieurs plages métalliques du circuit oscillateur 15, non représentées, sont reliées de manière connue par des fils métalliques 16 à des plages métalliques internes du boîtier. Ces plages métalliques internes du boîtier, non représentées, sont disposées sur un support annulaire 17 venant de matière avec la paroi latérale 3 et la base 20. Ces plages métalliques internes sont reliées par des pistes de connexion, non représentées, à des bornes de connexion externes 13 disposées sur deux côtés du composant électronique 1.

Le second logement 18 est rempli d'une résine 19 pour encapsuler le circuit intégré 15 afin de le protéger mécaniquement et de la lumière. De cette façon, le composant électronique 1 terminé est configuré comme un composant de type SMD (sigle de l'appellation anglaise « Surface Mounting Device ») afin de pouvoir être monté par exemple sur une plaque de circuit imprimé.

Le circuit oscillateur 15 est également relié au résonateur à quartz 5 à travers la base 20 par deux pistes de connexion 14 de manière à produire des signaux à une fréquence dépendant de l'ajustage du résonateur. Ces pistes de connexion peuvent être réalisées en tungstène-nickel-or.

Pour la génération de signaux basse fréquence, le résonateur à quartz 5 doit être enfermé sous vide dans le logement 8 afin de pouvoir être ajusté ou réglé sur le composant électronique terminé par un faisceau laser comme décrit ci-devant. Cependant, il peut subsister une pression résiduelle dans le logement 8 de l'ordre de 1 mbar. De ce fait, une couche de chrome ou de titane 21 peut être déposée par exemple sur une partie de la face intérieure du couvercle 4 en tant que matériau du type getter. Cette couche de chrome ou de titane 21 peut servir de pompe à vide lorsqu'elle est activée notamment par un faisceau laser à travers le couvercle 4.

En activant cette couche 21 par faisceau laser, des particules de chrome ou de titane évaporées peuvent se déposer sur le résonateur et ainsi abaisser la fréquence d'oscillations. Par la suite, il est possible d'augmenter la fréquence du résonateur à ajuster en agissant directement sur les électrodes du résonateur.

Il est à noter que cette couche de chrome ou de titane 21 peut être déposée sur toute la face intérieure du couvercle 4 servant de couche d'accrochage pour la couche de dorure 11. De plus, la couche de chrome ou de titane peut être également placée à un autre endroit du logement 8, par exemple sur la base 20 ou sur le résonateur 5 pour autant qu'il soit possible de l'activer par un faisceau laser à travers le couvercle 4 du composant.

A partir de la description qui vient d'être faite de multiples variantes de réalisation du composant électronique peuvent être conçues par l'homme du métier sans sortir du cadre de l'invention définie par les revendications. Le composant électronique peut ne comprendre que l'élément résonateur.

Il peut être envisagé également de monter le circuit oscillateur dans le même logement que le résonateur à quartz. Ce circuit oscillateur peut comprendre également une fonction d'horloge à temps réel (RTC) ou d'autres fonctions.

Il peut être envisagé également de monter l'élément résonateur dans des boîtiers dont la partie principale peut être réalisée en métal ou en verre, comme cela a déjà été proposé pour des résonateurs à diapason classiques. Dans ce cas, il peut être prévu que la partie du rebord n'entoure que partiellement la surface latérale du couvercle par exemple les quatre coins du couvercle.

L'ajustage de l'élément résonateur peut être réalisé avant la fixation du couvercle sur le rebord de la paroi latérale du boîtier. Finalement, le logement comprenant l'élément résonateur peut ne pas comprendre de matériau du type getter.

## Revendications

1. Composant électronique (1) comprenant au moins un élément résonateur (5) disposé dans un logement (8) d'un boîtiers, qui comprend une partie principale (2) avec une base (20) et au moins une paroi latérale (3) de forme annulaire, et un couvercle (4), qui est en matériau friable ou cassable, étant fixé sur la partie principale pour fermer hermétiquement le logement du boîtier, au moins une portion du couvercle étant transparente à une longueur d'onde déterminée d'un faisceau de lumière pour permettre un réglage optique de l'élément résonateur, **caractérisé en ce que** le couvercle (4) est fixé sur un rebord (7) de la paroi latérale (3) de la partie principale, qui est réalisée en matériau dur, tel qu'en céramique, de manière qu'une partie du rebord entoure intégralement la surface latérale du couvercle (4) pour assurer une protection du couvercle du composant électronique contre des chocs latéraux, et **en ce qu'**il comprend un espace (22) entre la surface latérale du couvercle (4) et la partie du rebord (7) entourant le couvercle, l'espace étant de dimension inférieure à l'épaisseur du couvercle et agencé pour éviter de propager directement au couvercle des chocs latéraux pouvant survenir contre ledit rebord.

2. Composant électronique (1) selon la revendication 1, **caractérisé en ce que** la hauteur de la partie du rebord (7) entourant la surface latérale du couvercle (4) est plus grande ou égale à l'épaisseur du couvercle fixé sur le rebord.

3. Composant électronique (1) selon la revendication 1, **caractérisé en ce que** le couvercle transparent (4) est un couvercle en verre.

4. Composant électronique (1) selon la revendication 1, **caractérisé en ce que** le rebord (7) de la partie principale (2) du boîtier recevant le couvercle comprend une première couche annulaire de dorure (10), **en ce que** la périphérie d'une face intérieure du couvercle comprend une seconde couche annulaire de dorure (11), et **en ce que** le couvercle (4) est soudé sur le rebord à l'aide d'une préforme (9) en alliage métallique disposée entre les deux couches annulaires de dorure, l'alliage métallique pouvant être composé d'étain et d'or.

5. Composant électronique (1) selon la revendication 1, dans lequel le logement (8) de la partie principale (2) du boîtier, qui comprend l'élément résonateur (5), est fermé sous vide, **caractérisé en ce que** l'élément résonateur est un résonateur à quartz pouvant être réglé par un faisceau laser à travers la portion transparente du couvercle (4), ledit résonateur à quartz étant en forme de diapason avec deux branches parallèles (5a, 5b) reliées entre elles par un pont (5c) et portant des électrodes (6a, 6b) pour les faire vibrer, et **en ce que** la partie principale du boîtier comprend au moins un plot (12) solidaire de la base (20) sur lequel est fixé le diapason, lesdites électrodes étant reliées électriquement à travers la partie principale du boîtier à des bornes externes de connexion (13).

6. Composant électronique (1) selon la revendication 1, **caractérisé en ce qu'**il comprend un circuit oscillateur (15) connecté électriquement à l'élément résonateur (5).

7. Composant électronique (1) selon la revendication 6, **caractérisé en ce que** le circuit oscillateur (15) est disposé dans un second logement (18) de la partie principale (2), qui est délimité par la paroi latérale (3) et la base (20), le second logement étant disposé sur une face opposée de la base par rapport au logement (8) de l'élément résonateur (5), **en ce que** ledit circuit oscillateur, qui est encapsulé dans le second logement par une résine (19), est connecté électriquement à des bornes externes de connexion (13) du composant électronique, et **en ce que** la base de la partie principale du boîtier comprend des pistes de connexion électrique (14) pour relier électriquement le circuit oscillateur et l'élément résonateur.

8. Composant électronique (1) selon la revendication 1, **caractérisé en ce qu'**un matériau du type getter est disposé dans le logement (8) de l'élément résonateur (5) pour servir de pompe à vide lorsqu'il est activé.

9. Composant électronique (1) selon la revendication 8, **caractérisé en ce que** le matériau du type getter est une couche de titane ou de chrome (21) évaporée dans le logement (8) de l'élément résonateur, de préférence sur une partie de la face intérieure du couvercle (4), et **en ce que** cette couche de titane ou de chrome est susceptible d'être activée au moyen d'un faisceau laser à travers la portion transparente du couvercle (4) pour servir de pompe à vide et abaisser la fréquence d'oscillations de l'élément résonateur.

10. Procédé de fabrication d'un composant électronique selon l'une des revendications précédentes, le procédé comprenant une première série d'étapes consistant à réaliser la partie principale du boîtier par un empilement et une fixation de feuilles en céramique ouvragées pour définir une base et au moins une paroi latérale de forme annulaire, et à monter un élément résonateur dans un logement du boîtier, **caractérisé en ce que** le procédé comprend une seconde série d'étapes consistant à poser le couvercle sur le rebord de la partie principale, dont une partie entoure intégralement la surface latérale du couvercle, ledit couvercle étant positionné sur le rebord par la partie du rebord entourant la surface latérale du couvercle, et à fixer le couvercle sur le rebord en chauffant des couches métalliques disposées sur le rebord et le couvercle, un espace (22) de dimension inférieure à l'épaisseur du couvercle étant agencé entre la surface latérale du couvercle (4) fixé et la partie du rebord (7) entourant le couvercler pour éviter de propager directement au couvercle des chocs latéraux pouvant survenir contre le rebord.

## Claims

1. Electronic component (1) including at least one resonator element (5) arranged in a housing (8) of a case, which includes a main part (2) with a base (20) and at least one lateral wall (3) of annular shape, and a cover (4), which is in friable or breakable material, being fixed onto the main part to hermetically seal the housing of the case, at least one portion of the cover being transparent to a determined wavelength of a light beam to allow the resonator element to be optically adjusted, **characterised in that** the cover (4) is fixed onto a rim (7) of the lateral wall (3) of the main part, which is made of a hard material, such as a ceramic material, such that one part of the rim entirely surrounds the lateral surface of the cover (4) to ensure protection of the cover of the electronic component against lateral shocks, and **in that** it includes a space (22) between the lateral surface of the cover (4) and the part of the rim (7) surrounding the cover, the space being of smaller dimensions than the thickness of the cover and arranged to avoid to directly propagate on the cover lateral shocks able to occur against said rim.

2. Electronic component (1) according to claim 1, **characterised in that** the height of the part of the rim (7) surrounding the lateral surface of the cover (4) is larger than or equal to the thickness of the cover fixed onto the rim.

3. Electronic component (1) according to claim 1, **characterised in that** the transparent cover (4) is a glass cover.

4. Electronic component (1) according to claim 1, **characterised in that** the rim (7) of the main part (2) of the case receiving the cover includes a first annular layer of gold plating (10), **in that** the periphery of an inner face of the cover includes a second annular layer of gold plating (11), and **in that** the cover (4) is welded onto the rim using a metal alloy preform (9) arranged between the two annular layers of gold plating, the metal alloy being able to be formed of tin and gold.

5. Electronic component (1) according to claim 1, wherein the housing (8) of the main part (2) of the case, which includes the resonator element (5) is vacuum sealed, **characterised in that** the resonator element is a quartz resonator able to be adjusted by a laser beam through the transparent portion of the cover (4), said quartz resonator being in the form of a turning fork with two parallel arms (5a, 5b) connected to each other by a bridge (5c) and carrying electrodes (6a, 6b) to make them vibrate, and **in that** the main part of the case includes at least one stud (12) secured to the base (20) onto which the tuning fork is fixed, said electrodes being electrically connected through the main part of the case to external connection terminals (13).

6. Electronic component (1) according to claim 1, **characterised in that** it includes an oscillator circuit (15) electrically connected to the resonator element (5).

7. Electronic component (1) according to claim 6, **characterised in that** the oscillator circuit (15) is arranged in a second housing (18) of the main part (2), which is delimited by the lateral wall (3) and the base (20), the second housing being arranged on an opposite face of the base to the housing (8) of the resonator element (5), **in that** said oscillator circuit, which is encapsulated in the second housing by a resin (19), is electrically connected to external connection terminals (13) of the electronic component, and **in that** the base of the main part of the case includes electrical connection paths (14) for electrically connecting the oscillator circuit and the resonator element.

8. Electronic component (1) according to claim 1, **characterised in that** a getter type material is arranged in the housing (8) of the resonator element (5) to act as a vacuum pump when it is activated.

9. Electronic component (1) according to claim 8, **characterised in that** the getter type material is a layer of evaporated titanium or chromium (21) in the housing (8) of the resonator element, preferably on a part of the inner face of the cover (4), and **in that** this layer of titanium or chromium is capable of being activated by means of a laser beam through the transparent portion of the cover (4) to act as a vacuum pump and lower the oscillation frequency of the resonator element.

10. Method of manufacturing an electronic component according to any one of the preceding claims, the method including a first series of steps consisting in making the main part of the case by stacking and fixing sheets of ceramic material, worked to define a base and at least one lateral wall of annular shape, and mounting a resonator element in a housing of the case, **characterised in that** the method includes a second series of steps consisting in placing the cover on the rim of the main part, one part of which entirely surrounds the lateral surface of the cover, said cover being positioned on the rim by the part of the rim surrounding the lateral surface of the cover, and fixing the cover onto the rim by heating metal layers arranged on the rim and the cover, a space (22) of smaller dimensions than the thickness of the cover being arranged between the lateral surface of the cover (4) and the part of the rim (7) surrounding the cover to avoid to directly propagate on the cover lateral shocks able to occur against said rim.

## Patentansprüche

1. Elektronisches Bauteil (1), das wenigstens ein Resonatorelement (5) umfasst, das in einem Aufnahmesitz (B) eines Gehäuses angeordnet ist, das einen Hauptteil (2) mit einer Basis (20) und wenigstens einer Seitenwand (3) in Ringform sowie einen Deckel (4), der aus einem brüchigen oder zerbrechlichen Material besteht und an dem Hauptteil befestigt ist, um den Aufnahmesitz des Gehäuses hermetisch zu verschließen, umfasst, wobei wenigstens ein Abschnitt des Deckels für eine bestimmte Wellenlänge eines Lichtstrahls durchlässig ist, um eine optische Einstellung des Resonatorelements zu ermöglichen, **dadurch gekennzeichnet, dass** der Deckel (4) an einem Rand (7) der Seitenwand (3) des Hauptteils befestigt ist, der aus einem harten Material wie etwa Keramik verwirklicht ist, derart, dass ein Teil des Randes die seitliche Oberfläche des Deckels (4) vollständig umgibt, um einen Schutz des Deckels des elektronischen Bauteils gegen seitliche Stöße zu gewährleisten, und dass es einen Zwischenraum (22) zwischen der seitlichen Oberfläche des Deckels (4) und dem den Deckel umgebenden Teil des Randes (7) aufweist, wobei der Zwischenraum eine Abmessung hat, die kleiner als die Dicke des Deckels ist, und angeordnet ist, um die direkte Ausbreitung von seitlichen Stößen, die auf den Rand auftreffen können, zu dem Deckel zu vermeiden.

2. Elektronisches Bauteil (1) nach Anspruch 1, **dadurch gekennzeichnet, dass** die Höhe des die seitliche Oberfläche des Deckels (4) umgebenden Teils des Randes (7) größer oder gleich der Dicke des Deckels ist, der an dem Rand befestigt ist.

3. Elektronisches Bauteil (1) nach Anspruch 1, **dadurch gekennzeichnet, dass** der lichtdurchlässige Deckel (4) ein Glasdeckel ist.

4. Elektronisches Bauteil (1) nach Anspruch 1, **dadurch gekennzeichnet, dass** der Rand (7) des Hauptteils (2) des Gehäuses, der den Deckel aufnimmt, eine erste ringförmige Vergoldungsschicht (10) aufweist, dass der Umfang einer inneren Fläche des Deckels eine zweite ringförmig Vergoldungsschicht (11) aufweist und dass der Deckel (4) auf den Rand mit Hilfe eines Vorformlings (9) aus einer Metalllegierung, der zwischen den zwei ringförmigen Vergoldungsschichten angeordnet ist, geschweißt ist, wobei die Metalllegierung aus Zinn und Gold zusammengesetzt sein kann.

5. Elektronisches Bauteil (1) nach Anspruch 1, wobei der Aufnahmesitz (8) des Hauptteils (2) des Gehäuses, der das Resonatorelement (5) enthält, vakuumdicht verschlossen ist, **dadurch gekennzeichnet, dass** das Resonatorelement ein Quarzresonator ist, der durch ein Laserstrahlenbündel durch den lichtdurchlässigen Abschnitt des Deckels (4) eingestellt werden kann, wobei der Quarzresonator die Form einer Stimmgabel mit zwei parallelen Schenkeln (5a, 5b), die durch eine Brücke (5c) miteinander verbunden sind und Elektroden (6a, 6b) tragen, um sie vibrieren zu lassen, hat, und dass der Hauptteil des Gehäuses wenigstens eine Anschlussfläche (12) aufweist, die mit der Basis (20) fest verbunden ist, auf der die Stimmgabel befestigt ist, wobei die Elektroden durch den Hauptteil des Gehäuses mit äußeren Verbindungsanschlüssen (13) elektrisch verbunden sind.

6. Elektronisches Bauteil (1) nach Anspruch 1, **dadurch gekennzeichnet, dass** es eine Oszillatorschaltung (15) umfasst, die mit dem Resonatorelement (5) elektrisch verbunden ist.

7. Elektronisches Bauteil (1) nach Anspruch 6, **dadurch gekennzeichnet, dass** die Oszillatorschaltung (15) in einem zweiten Aufnahmesitz (18) des Hauptteils (2) angeordnet ist, der durch die Seitenwand (3) und die Basis (20) begrenzt ist, wobei der zweite Aufnahmesitz in Bezug auf den Aufnahmesitz (8) des Resonatorelements (5) auf einer Fläche gegenüber der Basis angeordnet ist, dass die Oszillatorschaltung, die in dem zweiten Aufnahmesitz (19) durch ein Harz eingekapselt ist, mit äußeren Verbindungsanschlüssen (13) des elektronischen Bauteils elektrisch verbunden ist und dass die Basis des Hauptteils des Gehäuses elektrische Anschlussbahnen (14) aufweist, um die Oszillatorschaltung mit dem Resonatorelement elektrisch zu verbinden.

8. Elektronisches Bauteil (1) nach Anspruch 1, **dadurch gekennzeichnet, dass** in dem Aufnahmesitz (8) des Resonatorelements (5) ein Material des Getter-Typs angeordnet ist, um als Vakuumpumpe zu dienen, wenn es aktiviert ist.

9. Elektronisches Bauteil (1) nach Anspruch 8, **dadurch gekennzeichnet, dass** das Material des Getter-Typs eine Titan- oder Chromschicht (21) ist, die in dem Aufnahmesitz (8) des Resonatorelements vorzugsweise auf einen Teil der inneren Fläche des Deckels (4) aufgedampft ist, und dass diese Titan- oder Chromschicht mittels eines Laserstrahlenbündels durch den lichtdurchlässigen Abschnitt des Deckels (4) hindurch aktiviert werden kann, um als Vakuumpumpe zu dienen und um die Oszillationsfrequenz des Resonatorelements zu senken.

10. Verfahren für die Herstellung eines elektronischen Bauteils nach einem der vorhergehenden Ansprüche, wobei das Verfahren eine erste Reihe von Schritten umfasst, die darin bestehen, den Hauptteil des Gehäuses durch ein Stapeln und ein Befestigen von verzierten Keramiklagen herzustellen, um eine Basis und wenigstens eine Seitenwand mit Ringform zu definieren, und ein Resonatorelement in einem Aufnahmesitz des Gehäuses zu montieren, **dadurch gekennzeichnet, dass** das Verfahren eine zweite Reihe von Schritten umfasst, die darin bestehen, den Deckel auf den Rand des Hauptteils, wovon ein Teil die seitliche Oberfläche des Deckels vollständig umgibt, zu legen, wobei der Deckel durch den die seitliche Oberfläche des Deckels umgebenden Teil des Randes auf dem Rand positioniert wird, und den Deckel auf dem Rand durch Erhitzen der Metallschichten, die auf dem Rand und dem Deckel angeordnet sind, zu befestigen, wobei ein Zwischenraum (22) mit einer Abmessung, die kleiner als die Dicke des Deckels ist, zwischen der seitlichen Oberfläche des befestigten Deckels (4) und dem den Deckel umgebenden Teil des Randes (7) angeordnet ist, um zu vermeiden, dass sich seitliche Stöße, die auf den Rand wirken können, direkt zu dem Deckel ausbreiten.
